## Europäisches Patentamt
## European Patent Office
## Office européen des brevets

(19)

(11) Veröffentlichungsnummer: **0 005 847**
**B1**

(12) **EUROPÄISCHE PATENTSCHRIFT**

(45) Veröffentlichungstag der Patentschrift: **09.06.82**

(21) Anmeldenummer: **79101702.3**

(22) Anmeldetag: **01.06.79**

(51) Int. Cl.³: **G 11 C 11/40,**
**H 03 K 19/02,**
**H 03 K 3/353,**
**G 11 C 11/00, G 11 C 17/00**
**//H01L29/62, H03K3/356**

(54) Speicherschaltung und deren Verwendung in einer elektrisch programmierbaren logischen Anordnung.

(30) Priorität: **05.06.78 US 912682**

(43) Veröffentlichungstag der Anmeldung:
**12.12.79 Patentblatt 79/25**

(45) Bekanntmachung des Hinweises auf die Patenterteilung:
**09.06.82 Patentblatt 82/23**

(84) Benannte Vertragsstaaten:
**DE FR GB**

(56) Entgegenhaltungen:
**EP - A - 0 002 486**
**DE - A - 2 636 377**
**GB - A - 1 444 084**
**US - A - 3 394 356**
**US - A - 3 662 351**
**US - A - 3 820 086**
**US - A - 3 987 286**
**US - A - 4 021 786**
**US - A - 4 053 873**
**US - A - 4 140 967**

(73) Patentinhaber: **International Business Machines Corporation**
**Armonk, N.Y. 10504 (US)**

(72) Erfinder: **Balasubramanian, Peruvemba S.**
**1409 Johnson Court Boulder County**
**Boulder, Colorado 80303 (US)**
Erfinder: **Greenspan, Stephen B.**
**740 S. W. 17th Street**
**Boca Raton Florida 33 432 (US)**

(74) Vertreter: **Böhmer, Hans Erich, Dipl.-Ing.**
**Schönaicher Strasse 220**
**D-7030 Böblingen (DE)**

(56) Entgegenhaltungen:
**IBM TECHNICAL DISCLOSURE BULLETIN Vol. 14, Nr. 12, Mai 1972, Armonk, U.S. BAITINGER et al.: "Monolithic storage cell with FET's", Seiten 3640—3641**
**IBM TECHNICAL DISCLOSURE BULLETIN Vol. 17, Nr. 7, Dezember 1974, Armonk, U.S. CAVALIERE et al.: "Writable array logic cell", Seiten 1967—1968**

**0 005 847**

(56) Entgegenhaltungen:
IBM TECHNICAL DISCLOSURE BULLETIN Vol.
17, Nr. 12, Mai 1975, Armonk, U.S.
BALASUBRAMANIAN et al.: Monolithic storage
cell having inherent latent image memory
operation, Seiten 3634—3635
IBM JOURNAL OF RESEARCH &
DEVELOPMENT, Vol. 19, Nr. 2, März 1975,
Armonk, U.S., FLEISHER et al.: "An introduction
to array logic", Seiten 98—109
IBM JOURNAL OF RESEARCH &
DEVELOPMENT, Vol. 19, Nr. 4, Juli 1975,
Armonk, U.S., WOOD: "High speed dynamic
programmable logic array chip", Seiten 379—
383
IEEE INTERNATIONAL SOLID-STATE CIRCUITS
CONFERENCE, 16, Februar 1978, Digest of
technical papers New York, U.S., HEALD: "A
four-device bipolar memory cell", Seiten 102—
103
IEEE JOURNAL OF SOLID STATE CIRCUITS, Vol.
SC10, Nr. 5, Oktober 1975, New York, U.S.,
HORNINGER: "A high-speed ESFI-SOS
programmable logic array with an MNOS
version", Seiten 331—336
INTERNATIONAL ELECTRON DEVICES
MEETING, 5—7 Dezember 1977, Technical
Digest 1977, Washington, U.S., WALKER et al.:
"Four-transistor static MOS memory cells",
Seiten 402—405

# Speicherschaltung und deren Verwendung in einer elektrisch programmierbaren logischen Anordnung

Die Erfindung betrifft eine Speicherschaltung mit einer aus zwei über kreuz gekoppelten Transistoren aufgebauten bistabilen Kippschaltung, bei der der erste Transistor zwischen einem ersten Knotenpunkt und einer den Null-Zustand liefernden Spannung, und der zweite Transistor zwischen einem zweiten Knotenpunkt und der den Null-Zustand liefernden Spannung eingeschaltet ist, der erste Knotenpunkt an der Steuerelektrode des zweiten Transistors und der zweite Knotenpunkt an der Steuerelektrode des ersten Transistors angeschlossen ist, wobei der erste Transistor anfangs gesperrt und der zweite Transistor anfangs leitend ist, wobei ein Steuertransistor in den Stromkreis zwischen einem Sperrtransistor und einer Wortleitung eingeschaltet und mit seiner Steuerelektrode an einer Bit-Leitung angeschlossen ist, der Stromkreis von der Wortleitung über den Steuertransistor, den Sperrtransistor und den zweiten Transistor nach Masse einen ersten gespeicherten Informationszustand liefert, während der zweite Informationszustand durch eine Unterbrechung dieses Stromkreises am gesperrten Sperrtransistor gebildet ist, und der Leitzustand des Sperrtransistors durch die am ersten Knotenpunkt liegende Spannung steuerbar ist und deren Verwendung in einer programmierbaren logischen Anordnung.

Die Durchführung logischer Funktionen in einer Anordnung von identischen Schaltelementen, die jeweils an einem Schnittpunkt einer Eingangs- und einer Ausgangsleitung in einem Gitter von sich schneidenden Eingangs- und Ausgangsleitungen angeordnet sind, ist allgemein bekannt. Auch ist die Durchführung komplexer logischer Funktionen in einer sogenannten programmierbaren logischen Anordnung auf einem Halbleiterplättchen mit mehreren logischen Anordnungen dieser Art bekannt, wobei die Ausgangssignale einer Anordnung die Eingangssignale einer anderen Anordnung darstellen. Die DE—A—25 56 274 beschreibt eine solche programmierbare logische Anordnung (PLA), bei der eine Anzahl Decodierer Eingangssignale an einen ersten Bereich abgeben, der als Produktausdruckgenerator bezeichnet wird und eine Anordnung von UND-Gliedern darstellt, die wiederum Ausgangssignale an einen zweiten Bereich abgibt, der als Summe des Produktausdruckgenerators bezeichnet wird und einen aus ODER-Gliedern aufgebauten Bereich darstellt. Die Ausgangssignale dieses aus ODER-Gliedern bestehenden Bereichs werden dann zur Steuerung der Einstellung und Rückstellung einer Reihe von Verriegelungsschaltungen benutzt, so daß durch die PLA sowohl kombinatorische als auch sequentielle logische Funktionen durchgeführt werden können. Die durch die vorgegebene PLA tatsächlich durchgeführten bestimmten logischen Funktionen werden dabei durch die Orte und die Anzahl der aktiven logischen Schaltkreise der aus UND-Gliedern und ODER-Gliedern bestehenden PLA gesteuert und ferner dadurch, ob die Eingangssignale den Decodierern entweder von außerhalb des Halbleiterplättchens oder von den Verriegelungsschaltungen selbst zugeführt werden.

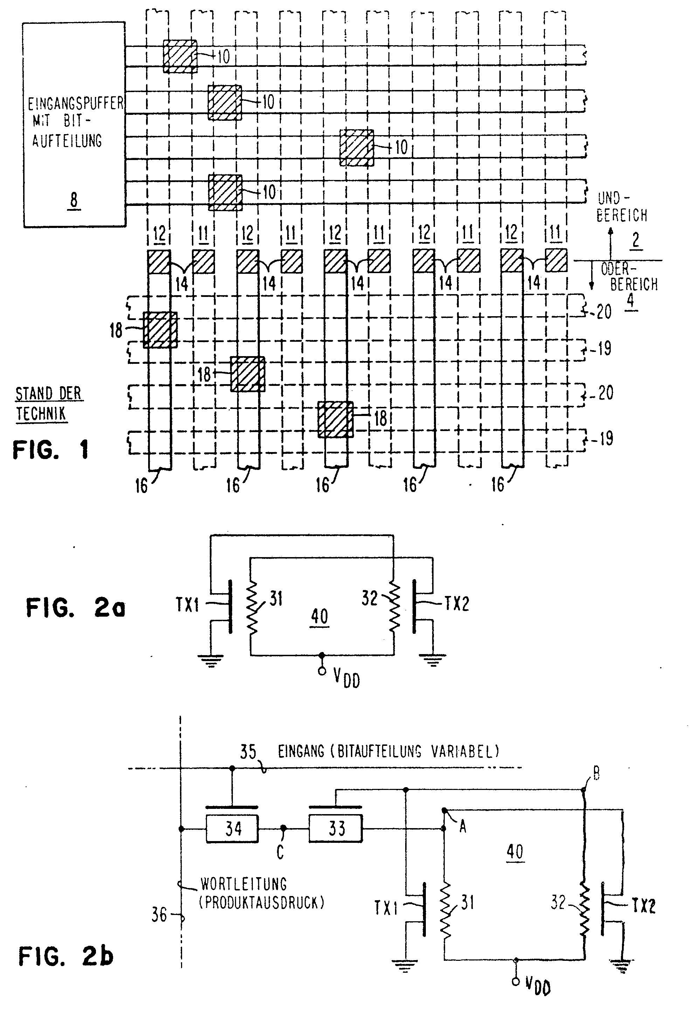

Fig. 1 zeigt eine übliche Ausführungsform einer PLA in MOSFET Technik mit den beiden aus UND-Gliedern bzw. ODER-Gliedern aufgebauten Bereichen 2 bzw. 4. Die vom Eingangspuffer 8 mit Bit-Aufteilung kommenden Eingangssignale werden dem aus UND-Gliedern aufgebauten Bereich 2 über eine Metallisierungsebene zugeführt, wodurch die Vorrichtungen 10 in dem aus UND-Gliedern aufgebauten Bereich 2 angesteuert werden, die dadurch aktiviert werden, daß dünne Oxidbereiche zwischen den Erdungsdiffusionen 11 und den Produktausdrucksdiffusionen 12 hergestellt sind. Die Ausgangssignale dieses UND-Bereichs 2 werden über diffundierte Produktausdruckleitungen 12 abgegeben. Wenn diese Produktausdrücke in den aus ODER-Gliedern aufgebauten Bereich 4 einlaufen, werden sie durch die Kontakte 14 in die Metallisierungsebene 16 überführt. Die Vorrichtungen 18 des aus ODER-Gliedern aufgebauten Bereichs 4 sind dann aktiv, wenn zwischen den Erddiffusionsbereichen 19 und den Ausgangsdiffusionsbereichen 20 einen dünne Oxidschicht erzeugt ist. Die Ausgangssignale des aus ODER-Gliedern bestehenden Bereichs 4 liegen auf den durch Diffusion erzeugten Leitungen 20. PLA-Schaltungen des Standes der Technik dieser Art benötigen für diese Anordnung eine relativ große Fläche auf dem Halbleiterplättchen, haben jedoch den Nachteil, daß die einzelnen UND- bzw. ODER-Glieder der Bereiche nicht ohne zusätzliche Eingangspuffer und Ausgangsverriegelungsschaltungen unabhängig voneinander überprüft werden können. Aus Gründen der Klarheit ist die Anordnung gemäß Fig. 1 nicht optimal ausgelegt, da eine zusätzliche vertikale Produktausdruckleitung für eine höhere Dichte zwischen Erddiffusionen angeordnet werden kann.

Übliche PLAs werden dadurch programmiert, daß man eine auf den bestimmten Verwendungszweck abgestimmte photolithographische Maske für die Definition dünner Oxid-Gatezonen für ausgewählte aus einer Anzahl möglicher Feldeffekttransistoren verwendet. Diese Art der Programmierung einer PLA hat zur Folge, daß die Programmierung später weder zum Korrigieren von Fehlern noch zur Durchführung von logischen Änderungen verändert werden kann. Das Maskenherstellungsverfahren ist außerdem zeitaufwendig und steht damit einem raschen logischen Entwurfsverfahren für hochintegrierte Schaltungen im Wege. Es ist daher wünschenswert, eine PLA elektrische programmierbar zu machen, wie dies beispielsweise von Horninger in IEEE Journal of Solid State Circuits Oktober 1975 (Seiten 331 bis 336) beschrieben wurde.

Eine derartige elektrisch programmierbare PLA ist ferner in der EP—A—2486 der Anmelderin offenbart, in welcher eine aus zwei Feldeffekttransistoren mit widerstandsbehafteter Gate-Elektrode bestehende Grundschaltung als statische Speicherzelle eingesetzt wird. Auf diese Speicherzelle wird noch näher eingegangen. Außerdem ist aus IBM Technical Disclosure Bulletin, Band 17, Nr. 7, Dezember 1974, Seiten 1967/68 eine aus zwei Paaren über kreuz gekoppelter, zueinander komplementärer Feldeffekttransistoren bestehende Speicherzelle für PLA bekannt, deren Speicher- oder Schaltzustand über ein NAND-Glied abfühlbar ist. Während die erstgenannte Zelle gegen Rückstellen nicht ausreichend gesichert ist, benötigt die letztgenannte Zelle mit insgesamt sechs Feldeffekttransistoren zuviel Platz.

Die der Erfindung zugrundeliegende Aufgabe besteht nun darin, eine Speicherschaltung der eingangs genannten Art zu schaffen, die sich zur Verwendung in einer elektrisch programmierbaren logischen Anordnung nach Art eines Festwert-Speichers (NUR-LESE-Speichers) eignet, keinen zusätzlichen Einstelltransistor benötigt und weniger Raum beansprucht. Dies wird erfindungsgemäß dadurch erreicht, daß der Sperrtransistor mit einer stromführenden Elektrode am zweiten Knotenpunkt und mit seiner Steuerelektrode am ersten Knotenpunkt angeschlossen ist und daß die Spannung am ersten Knotenpunkt von einem ersten Potential, bei dem der erste Transistor gesperrt ist, durch ein von der Wortleitung über den Steuertransistor und den Sperrtransistor nach der Steuerelektrode des ersten Transistors übertragenes Schreibspannungssignal wahlweise auf ein zweites Potential umschaltbar ist, so daß der erste Transistor leitend wird, wodurch die Kippschaltung umschaltet und den Sperrtransistor sperrt.

Die Erfindung wird nunmehr anhand eines Ausführungsbeispiels in Verbindung mit den beigefügten Zeichnungen im einzelnen erläutert.

In den Zeichnungen zeigt

Fig. 1 die Ausgestaltung einer dem Stand der Technik angehörenden, aus Feldeffekttransistoren aufgebauten programmierten logischen Anordnung,

Fig. 2A das Prinzipschaltbild einer selbstverriegelnden Speicherzelle mit Feldeffekttransistoren mit widerstandsbehafteten Gate-Elektroden gemäß der EP—A—2486 der Anmelderin,

Fig. 2B ein schematisches Schaltbild einer Zelle einer programmierbaren logischen Anordnung gemäß der Erfindung,

Fig. 3 ein Schaltbild einer programmierbaren logischen Anordnung unter Verwendung der in Fig. 2B dargestellten programmierbaren Zelle,

Fig. 4 ein Blockschaltbild einer Durchschaltsteuerung mit Bit-Aufteilung, und

Fig. 5 eine Draufsicht der programmierbaren PLA-Zelle, die schematisch in Fig. 2B dargestellt ist.

Beschreibung der bevorzugten Ausführungsform

Eine einschreibbare elektrisch programmierbare Speicherschaltung als Festwertspeicher wird beschrieben, bei welcher eine bistabile Kippschaltung zum Speichern des programmierten Leitzustandes eines Bauelements der Anordnung mit Hilfe eines Sperrtransistors verwendet wird, der zwischen dem Bauelement und einem Knotenpunkt der Kippschaltung eingeschaltet ist, wobei die Steuerelektrode des Sperrtransistors am andern Knotenpunkt der Kippschaltung angeschlossen ist. Befindet sich die Kippschaltung in ihrem Anfangsbetriebszustand, bei dem der Sperrtransistor leitend ist, dann kann ein durch Voraufladung erzeugtes Signal über das Bauelement der Anordnung nach Erde abgeleitet werden, was einen ersten gespeicherten Informationszustand anzeigt. Indem man ein Schreibsignal von so großer Amplitude, daß dadurch die bistabile Kippschaltung in ihren anderen Betriebszustand eingestellt werden kann, über das Bauelement der Anordnung und den Sperrtransistor leitet, wird der Sperrtransistor in seinen nichtleitenden Zustand überführt, so daß nachfolgende Versuche, ein Signal über das Bauelement der Anordnung nach Erde abzuleiten, nicht durchführbar sind, wodurch ein zweiter gespeicherter Informationszustand angezeigt wird. Diese Speicherschaltung wird als Speicherzelle in der Architektur einer programmierbaren logischen Anordnung eingesetzt, die gegenüber der üblichen, durch Maske programmierbaren Ausführungsform nur vier zusätzliche Anschlußstifte benötigt. Dies wird durch die zweifache Verwendung der Ausgangsverriegelungsschaltungen des ODER-Bereichs sowohl zum Auslesen der Anordnung als auch zum Programmieren der Anordnung durch das "Scan-in"-Verfahren erreicht. Die Zellen im UND-Bereich werden durch ein Produktausdruck-Programmierregister programmiert, duch das die Produktausdrücke durch eingangsseitige Schaltungen mit Bit-Aufteilung programmiert werden können.

Im folgenden soll somit die Organisation einer auf einem Halbleiterplättchen untergebrachten, elektrisch programmierbaren logischen Anordnung dargestellt werden, die eine selbsthaltende, aus Feldeffekttransistoren mit widerstandsbehafteter Gate-Elektrode aufgebaute Zelle gemäß Fig. 2A verwendet. An Stelle von Feldeffekttransistoren können auch bipolare Transistoren eingesetzt werden.

Fig. 2B zeigt die selbstverriegelnde Zelle 40 mit den entsprechenden Steuerungen für die Auswahl einer Programmierung und die Abfühlung der Programmierung der Zelle 40 wie folgt:

a) Wenn die Spannung $V_{DD}$ eingeschaltet wird, dann bewirkt die asymmetrische Konstruktion der Zelle, daß der Knotenpunkt A im Nullzustand und der Knotenpunkt B im Einszustand liegt, d.h. daß der transistor TX2 leitet und der Transistor TX1 gesperrt ist.

b) Die Auswahl dieser Zelle der Anordnung erfolgt über die Eingangsleitung 35, die in ihren Einszustand gebracht wird.

c) Die Wortleitung 36 wird auf ein hohes positives Potential $VD_1$ gebracht.

d) Wenn die Wortleitung 36 auf $VD_1$, liegt und die Eingangsleitung 35 im Zustand 1 ist, dann schaltet der Steuertransistor 34 ein, so daß der Knotenpunkt C auf ein Potential annähernd gleich $VD_1$ kommt.

e) Da die Gate-Elektrode des Sperrtransistors 33 das gleiche Potential hat wie der Knotenpunkt B, so wird der Sperrtransistor 33 zunächst eingeschaltet, wenn das Potential am Knotenpunkt C ansteigt.

f) Da die Transistoren 33 und 34 eingeschaltet sind, sieht der Knotenpunkt A ein positives Potential von der zuvor aufgeladenen Wortleitung 36 (Wortleitung=$VD_1$), und die selbstverriegelnde Zelle 40 ändert ihren Zustand derart, daß der Knotenpunkt A auf 1 und der Knotenpunkt B auf 0 geht.

g) Wenn der Knotenpunkt B auf 0 liegt, dann schaltet der Sperrtransistor 33 ab, so daß die Verriegelungsschaltung 40 von der Produktausdruck- oder Wortleitung 36 abgetrennt wird. Daher sieht der Schnittpunkt zwischen Produktausdruckleitung und Eingangsleitung aus wie ein nicht-personalisierter Kreuzungspunkt. Der Zustand A=0, B=1, entspricht daher der Bedingung für einen personalisierten Kreuzungspunkt, und der Zustand A=1 und B=0 entspricht der Bedingung für einen nicht-personalisierten Kreuzungspunkt.

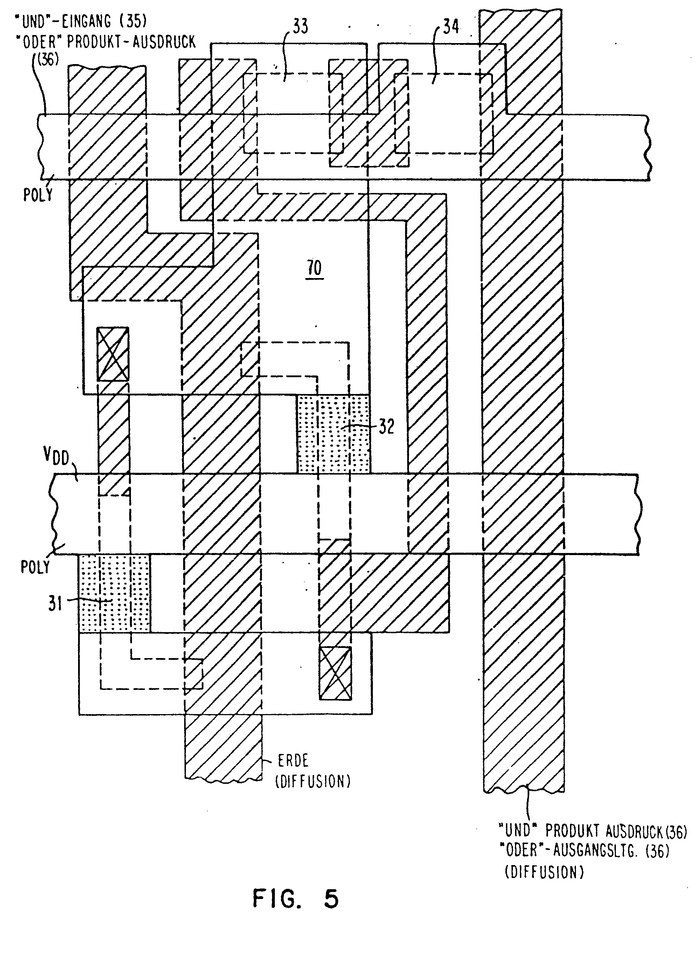

Der Aufbau der Zelle 40 ist dabei derart, daß in der PLA beim Einschalten (d.h., wenn $V_{DD}$ einen positiven Wert annimmt) alle Kreuzungspunkte personalisiert oder aktiv sind. Durch Programmierung lassen sich dann die einzelnen Kreuzungspunkte (Zellen 40) in einen äquivalenten, nicht-personalisierten Zustand überführen. Fig. 5 zeigt dabei den Aufbau einer Zelle gemäß Fig. 2B in einer Anordnung.

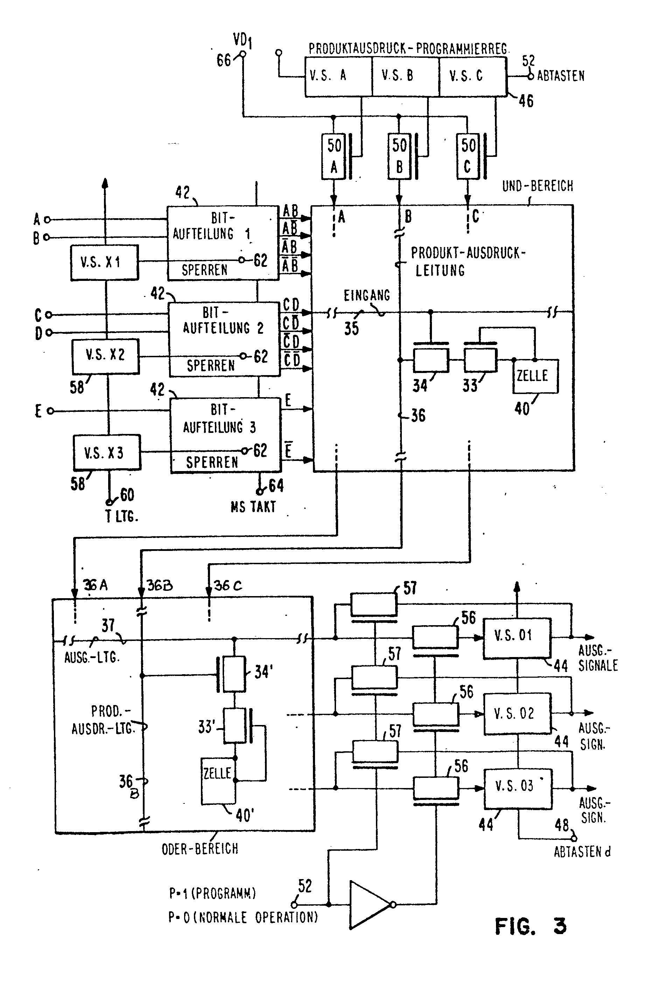

Fig. 3 zeigt eine programmierbare logische Anordnung auf einem Halbleiterplättchen. Diese Anordnung auf dem Halbleiterplättchen enthält:

a) UND/ODER-Bereiche, die aus besonders dichten, als Verriegelungsschaltung en wirkenden Zellen 40 bzw. 40' bestehen.

b) 1-Bit und 2-Bit-Schaltungen mit Bit-Aufteilung.

c) Ausgangsverriegelungsschaltungen 44 01, 44 02, 44 03, in denen die Ausgangssignale des ODER-Bereiches für vom Halbleiterplättchen abzugebende Signale, für nach den Eingängen 42 zurückzuführende Signale oder beide gespeichert werden. Diese Verriegelungsschaltungen sind mit einer eigenen Abtastleitung (Abtasten d) 48 für Prüfzwecke versehen.

d) Für die Programmierung steuert ein Produktausdruck-Programmierregister (PTPR) 46 die Übertragungsschaltungen 50A, 50B, 50C . . . 50n. Wenn eine Übertragungsschaltung 50 eingeschaltet ist, dann ist die zugehörige Produktausdruckleitung 36 an ein Potential $VD_1$ angeschlossen (ein positives Potential). Im PTPR-Register 46 liegende Steuerdaten werden fortlaufend nacheinander über die Klemme 52 abgetastet.

e) Für die Programmierung der Zellen des ODER-Bereichs werden die Transistoren 57 durch ein Signal an der Klemme 52 betätigt, so daß das am Rückkopplungsausgang der Verriegelungsschaltung 44 auftretende Datensignal (Einsen oder Nullen) die Ausgangsleitungen 37 des ODER-Bereichs einschaltet oder abschaltet. Zum gleichen Zeitpunkt werden die Transistoren 56 abgeschaltet, wodurch die Eingänge der Verriergelungsschaltungen 44 von den Betriebszuständen der Ausgangsleitungen 37 abgetrennt werden. Im Normalbetrieb mit P=0 an der Klemme 52 sind die Transistoren 57 gesperrt, so daß die Ausgangssignale der Verriegelungsschaltungen 44 von den Ausgangsleitungen 37 des ODER-Bereichs isoliert sind. Zum gleichen Zeitpunkt sind die Transistoren 56 eingeschaltet, so daß die Betriebszustände der Ausgangsleitungen 37 den Ausgangsverriegelungsschaltungen 44 zugeführt werden.

f) Für eine Programmierung der Zellen des UND-Bereiches wird ein Register 58 benutzt, das die Ausgangsbetriebszustände der Schaltung 42 mit Bit-Aufteilung durchschaltet. Das Register 58 besteht aus abtastbaren Verriegelungsschaltungen X1, X2 . . . Xn, wobei E/A-Muster über die T-Leitung 60 abgetastet werden. Das Durchschaltsignal 62 verhindert, daß die Ausgangssignale der Schaltung 42 in den 1-Zustand übergehen.

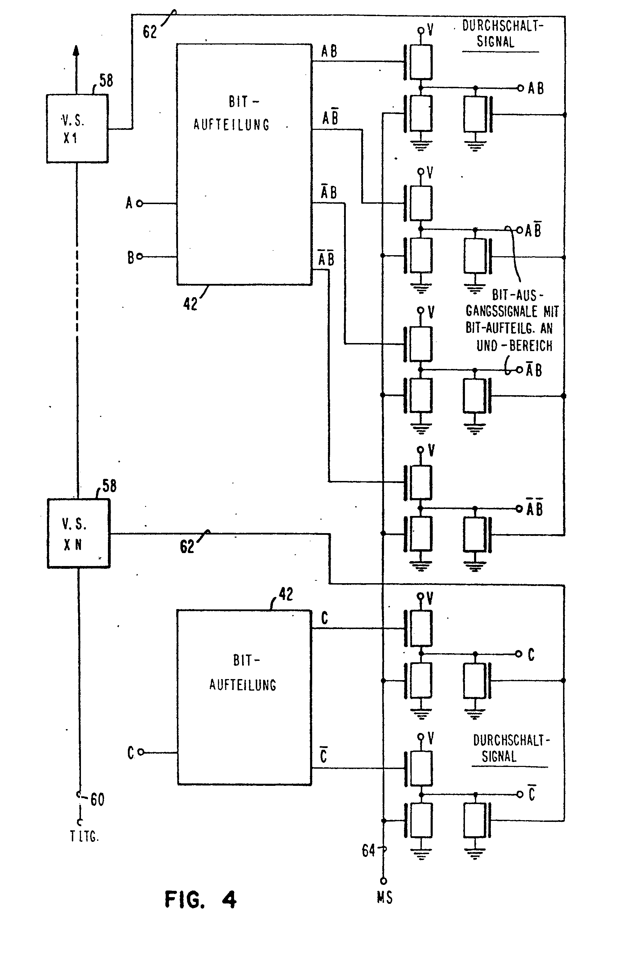

Wie in Fig. 4 gezeigt, bleiben dann, wenn das Durchschaltsignal 62 im 1-Zustand liegt, alle Ausgangssignale der Schaltung 42 im Nullzustand, wobei der Betriebszustand des Durchschaltsignals 62 durch den Betriebszustand der einzelnen Verriegelungsschaltungen X1, X2 . . . Xn bestimmt wird, die zusammen das Register 58 bilden. Dadurch wird sicher verhindert, daß eine nicht gewünschte Zelle des UND-Bereichs ausgewählt wird, wodurch sich der Anfangszustand ändern könnte. Dies ist dann der Fall, wenn eine gegebene Produktausdruckleitung 36 keine aktiven Eingangssignale von einer gegebenen Schaltung 42 erhält.

Programmierbare Operationen

1) Die Produktausdrucksleitung 36A wird über den Transistor 50A, der durch Ansteuerung der Gate-Elektrode des Transistors 50A durch PTPR 46 eingeschaltet wird, auf das Potential

VD$_1$ gebracht. Alle anderen Produktausdrucksleitungen bleiben potentialfrei (die Transistoren
50B, 50C sind gesperrt). Der Abtast-P-Datenstrom wäre für die PTPR Stuften mit Verriegelungsschaltung A, Verriegelungsschaltung B
bzw. Verriegelungsschaltung C in diesem Fall
100.

2) Wenn die Produktausdrucksleitung 36 auf
VD$_1$, liegt, werden Eingangsvariable A, B usw.
festgelegt, die die richtigen Ausgangsbetriebszustände der Schaltung 42 mit Bit-Aufteilung
liefern. Jeder Ausgangsbetriebszustand 1 hat
zur Folge, daß der Ort der Zelle 40 ausgewählt
und diese gekippt wird (Knotenpunkt A in der
Zelle 40 geht von 0 auf 1 über), so daß der
ausgewählte Kreuzungspunkt abgeschaltet
wird.

3) Wenn für eine gegebene Schaltung 42 gefordert wird, daß keines der Ausgangssignale im
1-Zustand liegt, dann wird diese Schaltung 42
durch das Durchschaltsignal 62, veranlaßt
durch die Verriegelungsschaltungen des Registers 58, durchgeschaltet.

4) Während die Produktausdrucksleitung 36
auf dem Potential VD$_1$ liegt, werden die Zellen
40' des ODER-Bereichs durch Einstellen der
Ausgangsleitungen 37 über die Ausgangsverriegelungsschaltung 44 und die Transistoren 57 in den 1- oder 0-Zustand programmiert. Die Betriebszustände der Ausgangsleitung 37 werden in der entsprechenden
Ausgangsverriegelungsschaltung durch den
serialen Datenstrom am Stift "Abtasten d 48"
festgelegt.

5) Wenn die Produktausdrucksleitung 36A
auf VD$_1$ liegt, dann werden die Eingänge A, B
usw. des UND-Bereiches zyklisch betätigt und
liefern so viele abgeschaltete Kreuzungspunktzellen 40, wie für den Produktausdruck 36A
erforderlich sind.

6) Diese Verfahrensschritte werden für den
Produktausdruck 36B, dann 36C so lange
wiederholt, bis alle Produktausdrücke 36 im
UND-Bereich und im ODER-Bereich programmiert sind.

Normalbetrieb
a) Das PTPR-Register 46 wird für eine interne
Operation Produktausdruck/Wortleitung 36 mit
Einsen geladen.
b) Durchshaltsignale 62 lassen die normalen
Ausgangssignale mit Bit-Aufteilung nach dem
UND-Bereich durchlaufen.
c) P=0 an Klemme 52.

Unter diesen Bedingungen tritt folgendes ein:
Ein Zyklus beginnt damit, daß alle Wortleitungen 36 auf den 1-Zustand aufgeladen
werden. Die Produktausdrücke 36 werden nur
dann über eine Zelle 40 entladen, wenn der
Knotenpunkt A in einer Zelle 40 sich auf dem
Potential 0 befindet (aktivierter personalisierter
Kreuzungspunkt). Wenn die Zellen 40 zuvor in
den inaktiven Zustand programmiert waren
(wobei Knotenpunkt A=1), dann ist die Zelle 40 durch den Transistor 33 von der Produktausdrucksleitung 36 isoliert.
Die erneute Programmierung der PLA (durch
eine digital gesteuerte Programmierung) würde
einen erneuten Zyklus der an die PLA angelegten Spannung V$_{DD}$ erfordern.
Zusammenfassend kann gesagt werden, daß
hier eine programmierbare logische Anordnung
beschrieben worden ist, die
1) vier zusätzliche Anschlußstifte (VD$_1$ 66,
Abtasten P 52, T Leitung 60, P 53) über die für
eine mit Masken programmierbare Anordnung
erforderlichen Stifte benötigt.
2) Gegenüber der mit Masken programmierbaren Ausführungsform werden etwa 20%
zusätzliche Oberfläche für das Halbleiterplättchen benötigt.
3) Erfordert eine einfache Verarbeitung der
Gate-Elektroden aus polykristallinem Silicium.
Punkt 1 ergibt eine steckbare Anordnung, die
der mit Masken programmierbaren Ausführungsform äquivalent ist.
Punkt 2 ergibt annehmbare Kosten.
Fig. 5 zeigt die Anordnung einer FET Kippschaltung mit widerstandsbehafteten Gate-
Elektroden in einer elektrisch programmierbaren logischen Anordnung. Die in Fig. 5
verwendeten Bezugszeichen entsprechen denen
der Fig. 2B. Die UND-Eingangsleitung 35 ist
eine aus polykristallinem Silicium oder Metall
bestehende Leitung der zweiten Leitungsebene
und bildet die Gate-Elektroden für den Transistor 34. Die polykristalline Siliciumschicht 70
ist eine leitende Schicht der ersten Leitungsebene und bildet die Knotenpunkte A und B der
Zelle 40 in Fig. 2B und ist so geformt, daß sie
die Gate-Elektrode für den Transistor 33, die
Gate-Elektrode 32 für den Transistor TX2 und
die Gate-Elektrode 31 für den Transistor TX1
der bistabilen Kippschaltung bildet. Die polykristalline Siliciumschicht 70 ist so strukturiert,
daß sie für die Gatezonen 31 und 32 und für
den Rest der Schicht einen höheren spezifischen
Widerstand aufweist.
Die sich dadurch ergebende elektrisch programmierbare logische Anordnung hat die
Eigenschaft, daß die Bauelemente der Anordnung in der PLA dadurch programmiert werden
können, daß der Betriebszustand der Speichervorrichtungen über die Wortleitung der Matrix
zwangsläufig verändert wird, so daß die Anzahl
der Leitungszüge, die für die Programmierbarkeit erforderlich ist, verringert wird, womit
die Anzahl der Stifte mit der für eine durch
Masken programmierbare PLA erforderlichen
Anzahl von Stiften vergleichbar bleibt, während
gleichzeitig gegenüber durch Masken programmierbaren PLAs die für die Änderung
der Programmierung erforderlich Zeit stark verringert ist. Die verbesserte Anordnung der elektrische programmierbaren PLA gibt eine höhere
Speicherdichte, so daß in hohem Maße
komplexe logische Funktionen auf einen kleinen
Oberflächenbereich eines Halbleiterplättchens
konzentriert werden können, wobei diese Funktionen im Bedarfsfall auf Echtzeitbasis geändert werden können, so daß man eine außerordentlich leistungsfähige logische Schaltung erhält. Die in Fig. 5 dargestellte Anordnung der einzelnen Schichten und Zonen ist mit den bestehenden Herstellungsverfahren für Feldeffekttransistoren verträglich, d.h. mit kombiniertem Metall-Gate-, Polisilicium-Gate- oder Doppelpolisilicium-Gate-Verfahren, die mot Vorteil die selbstausrichtenden Eigenschaften für die Transistoren ausnutzen, so daß sich für die dabei aufgebauten Schaltungen noch eine größere Packungsdichte ergibt.

**Patentansprüche**

1. Speicherschaltung mit einer aus zwei über kreuz gekoppelten Transistoren aufgebauten bistabilen Kippschaltung, bei der der erste Transistor (TX1) zwischen einem ersten Knotenpunkt (B) und einer den Null-Zustand liefernden Spannung, und der zweite Transistor (TX2) zwischen einem zweiten Knotenpunkt (A) und der den Null-Zustand liefernden Spannung eingeschaltet ist, der erste Knotenpunkt (B) an der Steuerelektrode (32) des zweiten Transistors (TX2) und der zweite Knotenpunkt (A) an der Steuerelektrode (31) des ersten Transistors (TX1) angeschlossen ist, wobei der erste Transistor anfangs gesperrt und der zweite Transistor anfangs leitend ist, wobei ein Steuertransistor (34) in den Stromkreis zwischen einem Sperrtransistor (33) und einer Wortleitung (36) eingeschaltet und mit seiner Steuerelektrode an einer Bit-Leitung (35) angeschlossen ist, der Stromkreis von der Wortleitung (36) über den Steuertransistor (34), den Sperrtransistor (33) und den zweiten Transistor (TX2) nach Masse einen ersten gespeicherten Informationszustand liefert, während der zweite Informationszustand durch eine Unterbrechung dieses Stromkreises am gesperrten Sperrtransistor (33) gebildet ist, und der Leitzustand des Sperrtransistors (33) durch die am ersten Knotenpunkt (B) liegende Spannung steuerbar ist, dadurch gekennzeichnet, daß der Sperrtransistor (33) mit einer stromführenden Elektrode am zweiten Knotenpunkt (A) und mit seiner Steuerelektrode am ersten Knotenpunkt (B) angeschlossen ist und daß die Spannung am ersten Knotenpunkt von einem ersten Potential, bei dem der erste Transistor gesperrt ist, durch ein von der Wortleitung (36) über den Steuertransistor (34) und den Sperrtransistor (33) nach der Steuerelektrode (31) des ersten Transistors (TX1) übertragenes Schreibspannungssignal wahlweise auf ein zweites Potential umschaltbar ist, so daß der erste Transistor (TX1) leitend wird, wodurch die Kippschaltung (40) umschaltet und den Sperrtransistor (33) sperrt.

2. Speicherschaltung nach Anspruch 1, dadurch gekennzeichnet, daß alle vier Transistoren (TX1, TX2, 33, 34) Feldeffekttransistoren sind.

3. Speicherschaltung nach Anspruch 1, dadurch gekennzeichnet, daß alle vier Transistoren (TX1, TX2, 33, 34) bipolare Transistoren sind.

4. Speicherschaltung nach Anspruch 1, dadurch gekennzeichnet, daß die bistabile Kippschaltung asymmetrisch aufgebaut ist, so daß beim Einschalten der Spannungsquelle der erste Transistor (TX1) gesperrt und der zweite Transistor (TX2) leitend ist.

5. Speicherschaltung nach Anspruch 1, dadurch gekennzeichnet, daß der erste Knotenpunkt (B) der Kippschaltung (40) an einer Signalquelle ($V_{DD}$) angeschlossen ist, die beim Anschalten den ersten Transistor (TX1) sperrt und den zweiten Transistor (TX2) entsperrt.

6. Elektrisch programmierbare logische Anordnung unter Verwendung von Speicherschaltungen gemäß Anspruch 1, die in Zeilen und Spalten angeordnet sind, wobei jede Zeile an einer Eingangsleitung und jede Spalte an einer Ausgangsleitung angeschlossen ist und die einzelnen Zellen in einen ihrer beiden Betriebszustände programmierbar sind, dadurch gekennzeichnet, daß zum elektrischen Programmieren im QDER-Bereich eine Anzahl Ausgangsverriegelungsschaltungen (44 01, 44 02, 44 03) vorgesehen ist, die jeweils mit einem ersten Eingang an einer der Ausgangsleitungen (37) zum Auslesen und Abspeichern des gespeicherten Zustandes der aufgerufenen Speicherzellen angeschlossen sind, daß diese Ausgangsverriegelungsschaltungen (44 01, 44 02, 44 03) einen zweiten Eingang (Abtasten d) zum Speichern eines Programmierimpulses und eine Rückkopplungsverbindung (57) vom Ausgang nach der jeweiligen Ausgangsleitung (37) aufweisen, für eine Übertragung des Programmierimpulses (von 52) an ausgewählte im Eins-Zustand befindliche Speicherzellen, so daß die Ausgangsverriegelungsschaltungen bei der Programmierung der Speicherzellen mitwirken.

7. Elektrisch programmierbare logische Anordnung nach Anspruch 6, dadurch gekennzeichnet, daß die Ausgangsverriegelungsschaltungen (44 01, 44 02, 44 03) über eine gemeinsame Abtastleitung (Abtasten d) hintereinander geschaltet sind und durch die Serie von Programmierimpulsen für Prüfzwecke und zur Anschaltung an die entsprechende Ausgangsleitung (37) ansteuerbar sind.

**Revendications**

1. Circuit de mémoire comportant une bascule bistable composées de deux transistors en montage croisé, dans lequel le premier transistor (TX1) est connecté entre un premier noeud (B) et une tension fournissant un état zéro, et le second transistor (TX2) est connecté entre un second noeud (A) et la tension fournissant l'état zéro, le premier noeud (B) est connecté à l'électrode de commande (32) du second transistor (TX2) et le second noeud (A) est connecté à l'électrode de commande (31) du premier transistor (TX1), le premier transistor étant initialement bloqué et le second transistor initialement conducteur, et un transistor de commande (34) étant inséré dans le chemin de courant entre un transistor de blocage (33) et une ligne de mot (36), son électrode de commande étant connectée à une ligne de bit (35), dans lequel le chemin de courant de la ligne de mot (36), à travers le transistor de commande (34), le transistor de blocage (33) et le second transistor (TX2) vers la masse, fournit un premier état d'information stockée alors que le second état d'information est obtenu par une interruption de ce chemin de courant au transistor de blocage bloqué (33), et dans lequel l'état de conductivité du transistor de blocage (33) peut être commandé par la tension appliquée au premier noeud (B), caractérisé en ce que: le transistor de blocage (33) est connecté par une électrode conductrice au second noeud (A) et par son électrode de commande au premier noeud (B), et en ce que la tension au premier noeud peut être sélectivement commutée d'un premier potentiel, où le premier transistor est non conducteur, à un second potentiel à l'aide d'un signal de tension d'écriture transmis de la ligne de mot (36) à travers le transistor de commande (34) et le transistor de blocage (33) à l'électrode de commande (31) du premier transistor (TX1) de telle sorte que le premier transistor (TX1) devienne conducteur, ce qui commute la bascule bistable (40) et bloque le transistor de blocage (33).

2. Circuit de mémoire selon la revendication 1, caractérisé en ce que les quatre transistors (TX1, TX2, 33, 34) sont des transistors à effet de champ.

3. Circuit de mémoire selon la revendication 1, caractérisé en ce que les quatre transistors (TX1, TX2, 33, 34) sont des transistors bipolaires.

4. Circuit de mémoire selon la revendication 1, caractérisé en ce que la bascule bistable a une structure asymétrique de sorte que, lors de la mise sous tension de la source de tension, le premier transistor (TX1) est bloqué et le second transistor (TX2) est conducteur.

5. Circuit de mémoire selon la revendication 1, caractérisé en ce que le premier noeud (B) de la bascule bistable (40) est connecté à une source de signaux ($V_{DD}$) qui lors de sa mise sous tension bloque le premier transistor (TX1) et débloque le second transistor (TX2).

6. Arrangement logique électriquement programmable qui utilise des circuits de mémoire selon la revendication 1, arrangés en lignes et en collones, chaque ligne étant connectée à une ligne d'entrée et chaque colonne à une ligne de sortie, les différentes cellules étant programmable dans l'un de leurs deux états de fonctionnement, caractérisé en ce qu'on utilise pur la programmation électrique dans la région OU, un certain nombre de circuits de verrouillage de sortie (44 01, 44 02, 44 03),

chacun ayant une première entrée connectée à une des lignes de sortie (37) pour lire et enregistrer l'état stocké des cellules de mémoire addressées, en ce que lesdits circuits de verrouillage de sortie (44 01, 44 02, 44 03) ont une seconde entrée (balayage d) pour stocker une impulsion de programmation et un circuit de réaction (57) de la sortie vers la ligne de sortie respective (37) pour transmettre l'impulsion de programmation (de 52) à des cellules de mémoire sélectionnées so trouvant dans l'état ''un'' de telle sorte que le circuit de verrouillage de sortie aide à programmer les cellules de mémoire.

7. Arrangement logique électriquement programmable selon la revendication 6, caractérisé en ce que les circuits de verrouillage de sortie (44 01, 44 02, 44 03) sont connectés en série à travers une ligne de balayage commune (balayage d) et peuvent être adressés par la série d'impulsions de programmation à des fins de tests et pour être connectés à la ligne de sortie correspondante (37).

## Claims

1. Memory circuit comprising a bistable flipflop having two cross-coupled transistors, wherein the first transistor (TX1) is arranged between a first node (B) and a reference voltage and the second transistor (TX2) is arranged between a second node (A) and the reference voltage, the first node (B) being connected to the control electrode (32) of the second transistor (TX2), and the second node (A) to the control electrode (31) of the first transistor (TX1), with the first transistor being initially in a non-conductive state and the second transistor being initially in a conductive state, a control transistor (34) inserted in the current path between a blocking transistor (33) and a word line (36) and having its control electrode connected to a bit line (35), the current path from the word line (36) via the control transistor (34), the blocking transistor (33) and the second transistor (TX2) representing a first stored information state, whereas the second information state is represented by an interruption of this current path at the blocked blocking transistor (33), and the conductive state of the blocking transistor (33) being controllable by the voltage applied to the first node (B), characterized in that the blocking transistor (33) has a conductive electrode connected to the second node (A), and has its control electrode connected to the first node (B), and that the voltage at the first node (A) is selectively switchable from a first potential, where the first transistor is non-conductive, to a second potential by a write voltage signal transmitted from the word line (36) via the control transistor (34) and the blocking transistor (33) to the control electrode (31) of the first transistor (TX1), so that the first transistor (TX1) is rendered conductive, whereby the flipflop (40) switches and renders the blocking transistor (33) non-conductive.

2. Memory circuit as claimed in claim 1, characterized in that all four transistors (TX1, TX2, 33, 34) are field effect transistors.

3. Memory circuit as claimed in claim 1, characterized in that all four transistors (TX1, TX2, 33, 34) are bipolar transistors.

4. Memory circuit as claimed in claim 1, characterized in that the bistable flipflop is of asymmetric design so that when the voltage source is switched on the first transistor (TX1) enters a non-conductive state and the second transistor (TX2) enters a conductive state.

5. Memory circuit as claimed in claim 1, characterized in that the first node (B) of the flipflop (40) is connected to a signal source ($V_{DD}$) which when switched on renders the first transistor (TX1) non-conductive and the second transistor (TX2) conductive.

6. Electrically programmable logic array using memory circuits as claimed in claim 1 arranged in rows and columns, each row being connected to an input line, and each column to an output line, and the individual cells being programmable in one of their two operating states, characterized in that for electrically programming in the OR region, a number of output latches (44 01, 44 02, 44 03) are provided, a first input of each being connected to one of the output lines (37) for reading and storing the stored state of the accessed storage cells, that these output latches (44 01, 44 02, 44 03) have a second input (scan d) for storing a programming pulse, and a feedback circuit (57) from the output to the respective output line (37) for transmitting the programming pulse (from 52) to selected storage cells in the One state so that the output latches contribute to the programming of the storage cells.

7. Electrically programmable logic array as claimed in claim 6, characterized in that the output latches (44 01, 44 02, 44 03) are connected in series via a common scan line (scan d), and that they can be accessed through the series of programming pulses for testing purposes and for switching to the corresponding output line (37).

STAND DER TECHNIK

**FIG. 1**

EINGANGSPUFFER MIT BIT-AUFTEILUNG

8

UND-BEREICH

ODER-BEREICH

**FIG. 2a**

TX1   31   40   32   TX2

V_DD

**FIG. 2b**

35  EINGANG (BITAUFTEILUNG VARIABEL)

WORTLEITUNG (PRODUKTAUSDRUCK)

36

34   C   33   A   B   40

TX1   31   32   TX2

V_DD

1

FIG. 3

FIG. 4

"UND"-EINGANG (35)
"ODER" PRODUKT-AUSDRUCK
(36)

33

34

POLY

70

V_DD

32

POLY

31

ERDE
(DIFFUSION)

"UND" PRODUKT AUSDRUCK (36)
"ODER"-AUSGANGSLTG. (36)
(DIFFUSION)

FIG. 5